# EUROPÄISCHE PATENTANMELDUNG

(11) **EP 1 134 694 A1**
(43) Veröffentlichungstag der Anmeldung: **19.09.2001**
(21) Anmeldenummer: 00105602.7
(22) Anmeldetag: 16.03.2000
(51) Int. Cl.: G06K 19/077

(54) **Dokument mit integrierter elektronischer Schaltung**

(71) Anmelder: Infineon Technologies AG, 81669 München (DE)
(72) Erfinder: Hofmann, Harald, 90766 Fuerth (DE)
(74) Vertreter: Hermann, Uwe, Dipl.-Ing.

(57) **Zusammenfassung**

Auf ein Blatt oder einen Streifen (1) aus Papier oder einem papierähnlichen Trägermaterial, z. B. einen Geldschein, ist eine elektronische Schaltung (2) aus organischem Halbleitermaterial aufgedruckt oder einlaminiert, die auch eine als Induktivität wirkende ebene Spirale (3) aufweisen oder mit dem Metallstreifen (4) eines Geldscheins über eine Leiterbahn (5) verbunden sein kann. Das Dokument kann eine Struktur übereinander laminierter Schichten besitzten, die außer einer Folie mit der darin ausgebildeten Schaltung noch mechanische oder elektrische Schutzschichten umfasst.

## Beschreibung

Die vorliegende Erfindung betrifft ein Dokument, insbesondere einen Geldschein, in das eine elektronische Schaltung in Halbleitertechnologie integriert ist, um das Dokument automatisch verfolgen oder seine Echtheit nachweisen zu können.

Es ist möglich, elektronische Schaltungen in Halbleitertechnologie so flach herzustellen, dass sie auf einem Blatt oder Streifen aus Papier oder einem papierähnlichen Trägermaterial aufgebracht und so in den Träger integriert werden können. Bekannt ist die Integration einer elektronischen Schaltung in Silizium-Halbleitertechnologie auf einem Geldschein, die den Sicherheitsmetallstreifen des Geldscheines als Antenne verwendet. Eine solche Schaltung ohne eigene Stromversorgung kann dazu verwendet werden, den Geldschein zu orten oder ein elektronisches Merkmal zur Erkennung der Echtheit des Zahlungsmittels nachzuweisen. Die elektronische Schaltung ist auf dem Geldschein aufgedruckt und bildet eine Art Etikett, das im heutigen Sprachgebrauch mit dem englischen Wort "Tag" bezeichnet wird.

Elektronische Schaltungen lassen sich statt in üblichen Halbleitermaterialien auch in organischen Verbindungen, die Halbleitereigenschaften aufweisen, herstellen. Es gibt z.B. sogenannte OFET als Feldeffekttransitoren in Polymer-Halbleitertechnologie. Es ist bekannt, mittels dieser organischen Halbleitertechnologie elektronische Schaltungen in Form von Tags oder Chipkarten herzustellen.

Aufgabe der vorliegenden Erfindung ist es, ein Dokument mit einer integrierten elektronischen Schaltung anzugeben, das bei hoher mechanischer Flexibilität einfach herstellbar ist.

Diese Aufgabe wird mit dem Dokument mit den Merkmalen des Anspruches 1 gelöst. Ausgestaltungen ergeben sich aus den abhängigen Ansprüchen.

Bei dem erfindungsgemäßen Dokument ist die integrierte elektronische Schaltung in einer organischen Halbleitertechnologie realisiert. Die Schaltung ist direkt auf das Trägermaterial des Dokumentes, z. B. einen Geldschein, aufgebracht oder als eigene Schicht auf einer Folie oder dergleichen in oder auf das Trägermaterial laminiert.

Es folgen nähere Erläuterungen von Beispielen der erfindungsgemäßen Dokumente mit integrierter elektronischer Schaltung anhand der Figuren 1 bis 6.
Die Figur 1 zeigt eine typische Ausgestaltung eines solchen Dokumentes.
Die Figuren 2 bis 5 zeigen Schichtstrukturen von Ausführungsbeispielen des Dokumentes im Querschnitt.
Die Figur 6 zeigt ein Ausführungsbeispiel ähnlich dem der Figur 5 in Aufsicht.

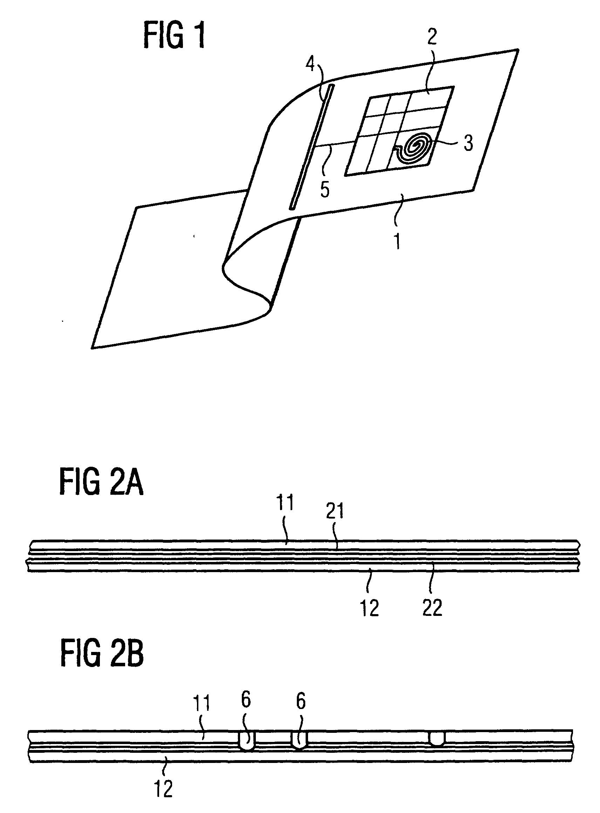

Das Dokument kann z.B. ein Geldschein sein, wie er im Prinzip in der Figur 1 dargestellt ist. Auf ein Blatt oder einen Streifen 1 aus Papier oder einem papierähnlichen Trägermaterial, hier einem Geldschein, ist eine elektronische Schaltung 2 aus organischem Halbleitermaterial aufgebracht. Die Schaltung kann eine als Spule (Induktivität) wirkende Komponente 3, die vorzugsweise als ebene Spirale ausgebildet ist, aufweisen. Eine Kontaktierung des in einem Geldschein vorhandenen Metallstreifens 4 mittels einer elektrisch leitenden Verbindung 5 ist hier ebenfalls möglich. Die Spirale, der Metallstreifen oder ein streifenförmiger Anteil des organischen Halbleitermaterials kann insbesondere als Antenne vorgesehen sein, mit der Signale empfangen und/oder z. B. an ein Terminal (Lesegerät, Ortungsgerät oder dergleichen) übermittelt werden können. Die Antenne kann sowohl bei induktiver als auch bei kapazitiver Kopplung direkt auf dem organischen Halbleitermaterial aufgebracht werden. Ein Metallstreifen kann so insbesondere durch einen elektrisch leitfähigen Kunststoffstreifen ersetzt sein, womit eine gesonderte Kontaktierung der Antenne an die elektronische Schaltung entfällt.

Die in organischer Halbleitertechnologie realisierte elektronische Schaltung kann direkt auf das Dokument, z.B. einen Geldschein, aufgedruckt sein. Dabei ist es zweckmäßig, als Trägermaterial dehnungsarmes Papier zu verwenden und das Layout und die Dimensionierung der Schaltung so zu gestalten, dass eine mögliche Dehnung des Papiers, die nicht ganz zu vermeiden ist, unschädlich ist. Zusätzlich kann eine Deckschicht als Schutzschicht über der Schaltung aufgebracht werden. Diese Schutzschicht kann auf der gesamten Oberfläche des Dokumentes vorhanden sein, was auch von den Abmessungen der Schaltung im Verhältnis zu der Gesamtfläche des Dokumentes abhängt.

Das Trägermaterial kann ein Laminat aus mindestens zwei Schichten aus Papier oder einem papierähnlichen Material sein. Die Schaltung wird bei der Herstellung des Dokumentes auf eine Trägerschicht oder anteilig auf beide Trägerschichten aufgebracht. Das kann z. B. mittels eines Offsetdruck-Verfahrens oder eines Inkjet-Verfahrens (Tintenstrahldruck) geschehen. Das Layout und die Dimensionierung der Schaltung sind hier ebenfalls zweckmäßig so zu gestalten, dass eine mögliche Dehnung des Papiers, die nicht ganz zu vermeiden ist, unschädlich ist.

In Figur 2A ist als Beispiel eine Anordnung aus zwei Trägerschichten 11, 12 mit jeweils darauf aufgebrachten Halbleiterschichten 21, 22 aus organischem Halbleitermaterial, die Anteile der Schaltung enthalten, im Querschnitt dargestellt. Die beiden Trägerschichten werden entsprechend der in Figur 2A gezeigten Ausrichtung so miteinander verbunden, dass die Schaltung zwischen den Trägerschichten angeordnet ist. Falls sich Anteile der Schaltung auf beiden Trägerschichten befinden, werden die Halbleiterschichten 21,22 nach Bedarf punktweise elektrisch leitend verbunden, z. B. indem entsprechend der schematischen Darstellung von Figur 2B eine Trägerschicht an den gewünschten elektrischen Kontaktstellen perforiert wird und eine geringe Menge eines elektrisch leitfähigen, vorzugsweise organischen, Materiales 6 dort eingespritzt wird. Alternativ kann eine entsprechende leitende Verbindung hergestellt werden, indem vor dem Verbinden der Schichten an den gewünschten elektrischen Kontaktstellen eine elektrisch leitende, vorzugsweise organische, Substanz auf einer Halbleiterschicht aufgebracht wird, die während des Laminierens mit den gegenüberliegenden Stellen der anderen Halbleiterschicht eine dauerhafte elektrisch leitende Verbindung eingeht.

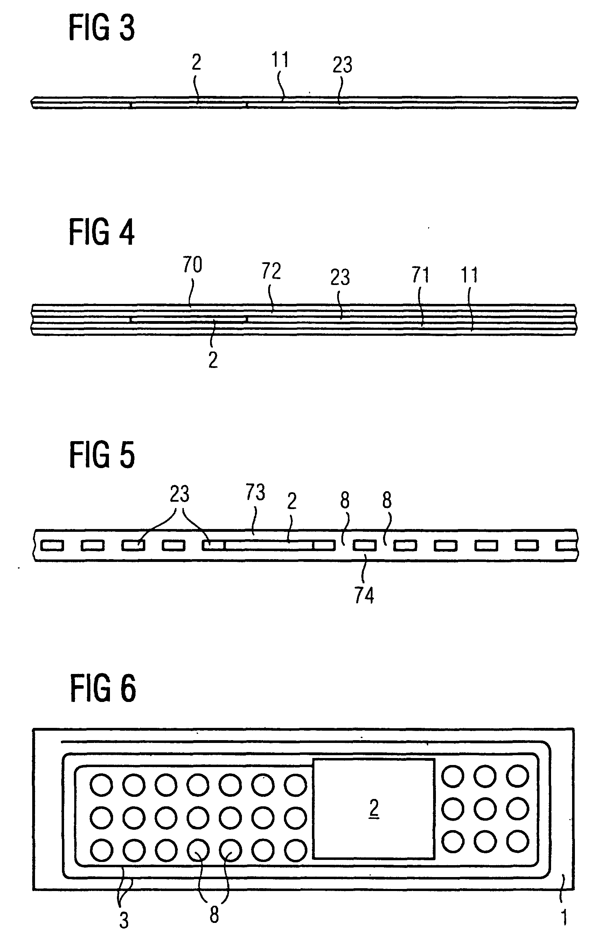

Ein alternatives Ausführungsbeispiel gemäß Figur 3 besitzt eine auf einer Trägerschicht 11 auflaminierte Folie 23 aus organischem Material, in der die elektronische Schaltung 2 ausgebildet ist (Sandwich-Struktur). Die Schaltung kann hierbei wie auch in den übrigen Ausführungsbeispielen die gesamte Fläche des Dokumentes oder, wie in der Figur 3 gezeichnet, nur einen Anteil der Fläche des Dokumentes einnehmen.

Figur 4 zeigt im Querschnitt eine Schichtstruktur eines erfindungsgemäßen Dokumentes, bei der eine Schicht oder Folie 23 mit der Schaltung 2, die in organischem Halbleitermaterial realisiert ist, auf einer Trägerschicht 11 angebracht ist. Zwischen diesen Schichten befindet sich eine elektrische Schutzschicht 71 zur Abschirmung (shield), die ebenfalls organisches Halbleitermaterial sein kann und insbesondere eine organische Halbleiterschaltung umfassen kann. Eine derartige elektrische Schutzschicht kann dafür vorgesehen sein, zu verhindern, dass in einer Schaltung gespeicherte Informationen ausgelesen oder manipuliert werden können.

Als weitere Schutzschichten sind in dem Beispiel der Figur 4 auf der von der Trägerschicht 11 abgewandten Oberseite des Dokumentes eine zweite elektrische Schutzschicht 72 und eine mechanische Schutzschicht 70 oder Deckschicht vorhanden. Derartige Schutzschichten können ganzflächig oder nur im Bereich der integrierten Schaltung einseitig oder beidseitig vorhanden sein. Es ist insbesondere möglich, mehrere Schichtlagen mit elektronischen Schaltungen in dem Dokument vorzusehen, die durch dazwischen angeordnete Schutzschichten elektrisch voneinander isoliert und allenfalls an den gewünschten Kontaktstellen elektrisch leitend miteinander verbunden sein können. Elektrische Schutzschichten mit den Eigenschaften der oben beschriebenen Schutzschicht 71 können als Abschirmungen jeweils über und unter den vorhandenen Halbleiterschichten vorhanden sein. Eine mechanische Schutzschicht als Deckschicht oder Passivierung auf einer oder beiden Oberseiten des Dokumentes dient zum Schutz gegen mechanische Beanspruchung wie Abrieb und dergleichen und wird aus einem dafür geeigneten, ausreichend strapazierfähigen Material aufgebracht.

In Figur 5 ist ein Ausführungsbeispiel dargestellt, bei dem die Schaltung 2 in einer Folie 23 oder organischen Halbleiterschicht ausgebildet ist, die Aussparungen oder Löcher 8 aufweist. Die Trägerschichten 73 und 74 sind hier beidseitig vorhanden und durch die Löcher 8 in der Folie 23 miteinander verbunden. Diese Strukturierung macht es möglich, eine innigere und dauerhaftere Verbindung zwischen den laminierten Schichten zu bewirken. Das ist insbesondere dann von Vorteil, wenn mit der eingesetzten Fertigungstechnik zwischen dem für die Schaltung verwendete organische Halbleitermaterial und dem als Trägermaterial verwendeten Papier keine ausreichende Haftung herstellbar ist. Es kann so auch eine ausreichende mechanische Verbindung zwischen zwei nicht laminierbaren Materialien hergestellt werden.

Figur 6 zeigt eine solche Ausgestaltung ähnlich dem Beispiel von Figur 5 in einer Aufsicht, in der die Schichtlage der Folie aus organischem Halbleitermaterial wiedergegeben ist. Die integrierte Schaltung 2, die im Prinzip beliebig strukturiert sein kann, ist schematisch mit ihren äußeren Umrissen eingezeichnet. Die in der Halbleiterschicht vorhandenen Löcher 8 können unterschiedliche geometrische Formen und Größen aufweisen und dem jeweiligen Bedarf entsprechend verteilt sein. Die Halbleiterschicht befindet sich zwischen zwei Schichten des Blattes oder Streifens 1, den das Trägermaterial des Dokumentes bildet, und ist in diesem Ausführungsbeispiel so strukturiert, dass eine Leiterschleife aus elektrisch leitendem Material der Folie als Spule 3 ausgebildet ist. Wegen der Größe der Leiterschleife, die rings um den Rand des Dokumentes verläuft, muss die Folie im Wesentlichen eine äußere Abmessung aufweisen, die der Abmessung des Dokumentes entspricht. Die Löcherstruktur der Halbleiterschicht ermöglicht es in diesem Fall, nicht nur eine verbesserte Laminierung zu erreichen, sondern auch in erheblichem Umfang Folienmaterial zu sparen. Eine derartig perforierte Folie kann auch direkt in die Papiermasse bei der Papierherstellung eingelegt werden. Drücke und Temperaturen bei der Verarbeitung werden so gewählt, dass die durch die organische Halbleiterschaltung bedingten einzuhaltenden Grenzwerte nicht überschritten werden.

Bei der Herstellung des erfindungsgemäßen Dokumentes können in demselben Arbeitsgang praktisch alle diejenigen elektronischen Komponenten hergestellt werden, die als ebene Leiterbahnen realisierbar sind. Das sind insbesondere Kondensatoren, die durch parallel zueinander verlaufende Leiterbahnen gebildet sind, und Spulen (Induktivitäten), die durch eine Vielzahl von parallel zueinander verlaufenden Leiterbahnen, vorzugsweise durch spiralige Anordnungen, gebildet werden. Eine derartige Spule oder eine Kapazität, die zwischen der elektronischen Schaltung und einem Lesegerät oder dergleichen zumindest zeitweilig besteht, kann als Antenne verwendet werden. Eine extra ausgebildete Kontaktierung einer beispielsweise durch eine metallische Leiterbahn gebildete Antenne ist dann unnötig.

Die elektronische Schaltung kann als Merkmal zur Erkennung von Fälschungen dienen. Die Schaltung kann ferner dazu dienen, das Dokument über die Schaltung zu orten, so dass eine automatische Verfolgung des Dokumentes, z. B. eines Geldscheines, möglich ist. Die Schaltung kann sowohl zur Ortung als auch zur Erkennung der Echtheit des Dokumentes verwendet werden. Das Dokument kann im Prinzip beliebige Eigenschaften aufweisen; es kann sich um ein Zahlungsmittel oder um eine Urkunde oder dergleichen handeln.

## Patentansprüche

1. Dokument als Blatt oder Streifen (1) aus Papier oder einem papierähnlichen Trägermaterial, auf oder in dem eine elektronische Schaltung (2) in Halbleitertechnologie integriert ist,
**dadurch gekennzeichnet, dass**
die Schaltung in einer organischen Halbleitertechnologie realisiert ist.

2. Dokument nach Anspruch 1, bei dem
die Schaltung mindestens einen OFET in Polymer-Halbleitertechnologie aufweist.

3. Dokument nach Anspruch 1 oder 2, bei dem
die Schaltung mindestens eine als Spule (Induktivität) wirkende Komponente (3) aufweist.

4. Dokument nach Anspruch 3, bei dem
die als Spule wirkende Komponente (3) als Antenne vorgesehen ist.

5. Dokument nach einem der Ansprüche 1 bis 4,
das mit einem Metallstreifen (4) ausgebildet ist und
bei dem der Metallstreifen elektrisch leitend mit der Schaltung verbunden und als Antenne vorgesehen ist.

6. Dokument nach einem der Ansprüche 1 bis 4,
das mit einem elektrisch leitfähigen Kunststoffstreifen (4) ausgebildet ist und
bei dem der Kunststoffstreifen elektrisch leitend mit der Schaltung verbunden und als Antenne vorgesehen ist.

7. Dokument nach einem der Ansprüche 1 bis 6,
das als Zahlungsmittel vorgesehen ist.

8. Dokument nach einem der Ansprüche 1 bis 7, bei dem
die Schaltung dafür vorgesehen ist, eine Ortung des Dokumentes vorzunehmen.

9. Dokument nach einem der Ansprüche 1 bis 8, bei dem
die Schaltung dafür vorgesehen ist, ein elektronisches Erkennungsmerkmal bereitzustellen.

10. Dokument nach einem der Ansprüche 1 bis 9, bei dem
die Schaltung in einer Halbleiterschicht (21, 22; 23) ausgebildet ist und
die Halbleiterschicht in einer laminierten Schichtfolge angeordnet ist.

11. Dokument nach Anspruch 10, bei dem
die laminierte Schichtfolge mindestens eine Trägerschicht (11, 12; 73, 74) und mindestens eine mechanische Schutzschicht (70) umfasst.

12. Dokument nach Anspruch 10 oder 11, bei dem
die laminierte Schichtfolge mindestens eine elektrische Schutzschicht (71, 72) als Abschirmung oder Isolation umfasst.

13. Dokument nach einem der Ansprüche 10 bis 12, bei dem
die Halbleiterschicht Löcher (8) oder Aussparungen aufweist und
diese Löcher oder Aussparungen mit dem Material einer angrenzenden Schicht der Schichtfolge gefüllt sind.
